# EUROPEAN PATENT APPLICATION

(11) **EP 2 801 551 A1**
(43) Date of publication of application: **12.11.2014**
(21) Application number: 13197029.5
(22) Date of filing: 12.12.2013
(51) Int. Cl.: C01B 31/04

(54) **Graphene with very high charge carrier mobility and preparation thereof**

(30) Priority: 08.05.2013 EP 13166948
(71) Applicant: Max-Planck-Gesellschaft zur Förderung der Wissenschaften e.V., 80539 München (DE); Georg-August-Universität Göttingen Stiftung Öffentlichen Rechts, 37073 Göttingen (DE)
(72) Inventor: Wodtke, Alec, Prof.Dr., 37083 Göttingen (DE); Yu, Hak Ki, Dr., 37075 Göttingen (DE)
(74) Representative: Manitz, Finsterwald & Partner GbR

(57) **Abstract**

The present invention relates to a graphene film, which is obtainable by a method comprising the steps of:
a) providing a substrate,
b) epitaxially growing a metal layer on a surface of the substrate,
c) optionally increasing the thickness of the metal layer obtained in step b) by growing a metal onto the epitaxially grown metal layer,
d) peeling off the metal layer obtained in step b) or optionally in step c) from the substrate and
e) depositing graphene onto at least a part of that surface of the metal layer obtained in step d), which was in contact with the substrate before the peeling off conducted in step d).

Such a graphene film has a very high charge carrier mobility, namely, when measured on a SiO₂ substrate, of more than 11000 cm²/V·sec, of at least 15000 cm²/V·sec, of at least 20000 cm²/V·sec, of at least 25000 cm²/V·sec or even of at least 30000 cm²/V·sec.

## Description

The present invention relates to a graphene film, to a method for producing the same and to the use thereof.

In the last few years considerable attention has been paid to graphene due to its outstanding properties. Particular interesting examples of the outstanding physical properties of graphene are its excellent electrical conductivity, its high optical transparency and its extraordinary high thermal conductivity. More specifically graphene is characterized by a very high charge carrier mobility and optical transparency, which explains why it is considered as a promising material for conductors in organic electronic devices, such as solar cells, organic light emitting electrodes, liquid crystal displays, touch screens or transistors, and in particular for transistors having a cycle time of 500 to 1000 GHz. Apart from that, graphene, due to its high thermal conductivity, is also attractive as a thermally conductive additive in materials, for which a high thermal conductivity is important. Furthermore, graphene has an excellent tensile strength and modulus of elasticity, which are of the order of magnitude of those of diamond.

Graphene is a carbon monolayer, in which the single carbon atoms are, as in graphite, hexagonally arranged and sp²-hybridised, wherein each carbon atom is surrounded by three further carbon atoms and covalently connected therewith. In other words, graphene is a carbon monolayer having a honeycomb-shaped hexagonal pattern of fused six-membered rings. Consequently, graphene is, strictly speaking, a single graphite layer and is characterized by a nearly infinite aspect ratio. However, in practice a few layers of graphite, such as graphite bilayers, are also denoted as graphene.

Also comprised by the term graphene as used in the present patent application is modified graphene, i.e. graphene, in which a low amount of atoms and/or molecules different from carbon atoms is contained. In particular, modified graphene is graphene, which is doped with atoms different from carbon atoms, such as with nitrogen and/or boron atoms.

Many methods for preparing graphene films are known.

One of the first methods for preparing graphene was the reduction of graphene oxide e.g. with hydrazine. The graphene oxide starting material may be obtained by oxidizing graphite with a strong acid, such as sulfuric acid, followed by intercalation and exfoliation in water. With this method, graphene monolayers having a size of 20 × 40 µm are available. However, one drawback of this method is that, due to the intercalation and exfoliation, some defects are present in the resulting graphene lattice, such as vacancies and partially sp³-hybridised carbon atoms. Due to this, the electrical conductivity and the charge carrier mobility of so produced graphene are quite low.

Another well-known method for the preparation of graphene is the exfoliation of graphite. In this method, an adhesive tape is used to repeatedly split graphite crystals into increasingly thinner pieces, before the tape with attached optically transparent flakes is dissolved e.g. in acetone and the flakes including graphene monolayers are sedimented on a silicon wafer. An alternative thereto is the sonication-driven exfoliation of graphite flakes in an organic solvent, such as dimethylformamide. In still a further alternative, the exfoliation of the graphite layers into graphene is effected by intercalating alkali metal ions, such as potassium ions, into the graphite and then exfoliation thereof in an organic solvent, such as tetrahydrofuran. However, these exfoliation based processes do not lead to monolayer graphene, but to graphene comprising monolayer sections, bilayer sections and the like, i.e. graphene with a high polydispersity. Apart from that, the graphene obtained with exfoliation based processes is very limited with respect to its flake size.

Another approach for preparing graphene films is the epitaxial growth of graphene on a metal substrate by means of chemical vapour deposition (CVD). Noble metals, such as platinum, ruthenium, iridium or the like, or other metals, such as nickel, cobalt, copper or the like, may be used as a metal substrate. However, typically a commercially available copper film is used as the metal substrate. These processes lead to high-quality graphene with a comparable large surface area. However, the charge carrier mobility of the so obtained graphene is typically smaller than that of graphene prepared by an exfoliation based method, which is presumably due to the fact that the resulting graphene consists of many graphene domains of small size and naturally with many domain boundaries between the individual domains. It is also possible that chemical impurities are introduced via the standard copper foil synthesis.

In order to increase the size of the graphene domains as well as to reduce the number of domain boundaries and thus to improve the electrical and thermal properties and in particular the charge carrier mobility of the graphene obtained by epitaxial growth of graphene on a metal substrate by means of CVD, it has been already proposed not to use a commercially available polycrystalline copper film as metal substrate, but to deposit the graphene by means of CVD on copper, which has been prepared by epitaxially depositing copper on a single-crystalline substrate, such as single-crystalline sapphire. Respective methods are disclosed for instance by Ago et al., "Catalytic Growth of Graphene: Toward Large-Area Single-Crystalline Graphene", J. Phys. Chem. Lett. 2012, vol. 3, pages 2228 to 2236 and by Hu et al., "Epitaxial growth of large-area single-layer graphene over Cu(111)/sapphire by atmospheric pressure CVD", Carbon 2012, vol. 50, pages 57 to 65.

More specifically, US 2012/0196074 A1 discloses a method, in which first cobalt or nickel metal is sputtered onto a c-plane sapphire in a thickness of 30 to 55 nm, before graphene is deposited by CVD onto the so obtained Co/- or Ni/c-plane sapphire. The CVD is performed e.g. in an atmosphere consisting of methane gas at a flow rate of 50 sccm and of hydrogen at a flow rate of 1500 sccm for 20 minutes at 900°C.

Moreover, EP 2 540 862 A1 discloses a carbon film laminate comprising a single-crystal substrate, a copper (111) single-crystal thin film formed by epitaxial growth of copper on the substrate and graphene formed on the copper (111) single-crystal thin film. Preferably, the copper (111) single-crystal thin film is deposited onto the single-crystal substrate by a DC magnetron sputtering method, whereas the graphene deposition onto the copper substrate is for instance effected by CVD performed in an atmosphere consisting of methane gas at a flow rate of 35 sccm and of hydrogen at a flow rate of 2 sccm for 20 minutes at 1000°C. The graphene obtained with this method is also said to have comparatively large crystal size of up to 100 mm². With this method graphene having a large crystal size is apparently obtained due to the use of a copper (111) single-crystal thin film as substrate for the deposition of the graphene. Although EP 2 540 862 A1 does not claim a high carrier mobility, publications, such as for example "Influence of Cu metal on the domain structure and carrier mobility in single-layer graphene", CARBON 50 (2012), pages 2189 to 2196, using this method have been reported and they are quite low, namely less than 2500 cm² V⁻¹ s⁻¹.

In summary, chemical exfoliation based methods and methods based on reduction of graphene oxide lead to comparable low-quality graphene, whereas the methods based on the epitaxial growth of graphene on a metal substrate by means of CVD lead to comparatively high-quality graphene, which has, however, a comparatively low electrical conductivity and low charge carrier mobility in comparison to the best exfoliated graphene.

The object underlying the present invention is to provide a high-quality graphene film having a large graphene domain size, having an excellent optical transparency and having an improved charge carrier mobility as well as a high thermal conductivity, an excellent tensile strength and a high modulus of elasticity.

According to the present invention this object is satisfied by providing a graphene film, which is obtainable with a process comprising the steps of:
a) providing a substrate,
b) epitaxially growing a metal layer on a surface of the substrate,
c) optionally increasing the thickness of the metal layer obtained in step b) by growing a metal onto the epitaxially grown metal layer,
d) peeling off the metal layer obtained in step b) or optionally in step c) from the substrate and
e) depositing graphene onto at least a part of that surface of the metal layer obtained in step d), which was in contact with the substrate before the peeling off conducted in step d).

This solution is based on the finding that by peeling off the epitaxially grown metal layer from the substrate, which is preferably a single-crystal substrate, before graphene is deposited on that surface of the peeled off metal layer, which was in contact with the substrate before the peeling off step, a graphene film is obtained which has an extraordinarily high charge carrier mobility, which comprises very large graphene domains, which has an excellent lattice quality and which has an excellent optical transparency. More specifically, the graphene according to the present invention has a charge carrier mobility of more than 11000 cm²/V·sec, namely preferably of at least 15000 cm²/V·sec, more preferably of at least 20000 cm²/V·sec, even more preferably of at least 25000 cm²/V·sec or even of at least 30000 cm²/V·sec, when measured on a SiO₂ substrate. In addition, the graphene according to the present invention is characterized by large graphene domains having an average diameter d₅₀ of more than 0.2 µm, preferably of at least 1 µm, more preferably of at least 5 µm, even more preferably of at least 10 µm, even more preferably of at least 50 µm and even more preferably of at least 100 µm. Furthermore, the graphene obtainable according to the present invention has an optical transparency of at least 95%, preferably of at least 97.5% and more preferably of at least 99%. Without wishing to be bound to any particular theory, it is contemplated that these surprising improved properties of the graphene according to the present invention are due, among other things, to the fact that the surface of the metal layer grown directly on the surface of the substrate, i.e. the surface of the peeled off metal layer, which was in contact with the substrate before the peeling off step, is much flatter and smoother than the surface opposite to this side and in particular than the surface of the metal layer grown thereon in the step c). Therefore, during the CVD step graphene is deposited on this smooth and flat surface with the formation of a high-quality lattice having large graphene domain sizes. Moreover, it is believed that the surface of the metal layer grown directly on the surface of the substrate, i.e. the surface of the peeled off metal layer, is protected during the method steps b) and c) from oxidation, so that no or only very little metal oxide, which would impair the quality of the graphene produced thereon, is formed thereon. In contrast to this, the graphene film is deposited in the prior art methods on the opposite side of the metal layer or on the surface of the metal layer grown thereon, respectively, which is subject to oxidation during the method and may not be as flat. All in all, the graphene according to the present invention is a high-quality graphene film having a large graphene domain size, having an excellent optical transparency and having an improved charge carrier mobility.

The term graphene denotes in the sense of the present invention a structure having at most 20 layers, each having a honeycomb-shaped hexagonal pattern of fused six-membered rings of sp²-hybridised carbon atoms. Preferably, graphene denotes a structure having at most 10 layers, more preferably at most 5 layers, even more preferably at most 4 layers, at most 3 layers, at most 2 layers and most preferably a mono-layer having a honeycomb-shaped hexagonal pattern of fused six-membered rings of sp²-hybridised carbon atoms. In line with this definition, the term graphene film denotes in the sense of the present invention not only a monolayer, but also a graphene bilayer, a tri-layer and so on up to a twenty-layer, wherein a graphene monolayer is most preferred. As set out above, the term graphene denotes in accordance with the present patent application also modified graphene, i.e. graphene, in which a low amount of atoms and/or molecules different from carbon atoms is contained. In particular, modified graphene is graphene, which is doped with atoms different from carbon atoms, such as with nitrogen and/or boron atoms.

As mentioned above, the advantageous properties of the graphene according to the present invention are among others due to the flatness and smoothness of the surface of the peeled off metal layer, which was in contact with the substrate before the peeling off step, wherein the flatness and smoothness of this surface is due to the fact that the metal layer is grown directly on the smooth and flat surface of the substrate. Particularly good results are obtained, when the substrate is a single-crystal substrate. In order to have a particularly good surface quality of the metal layer, it is preferred that the atomic spacing (lattice constant) of the single-crystal substrate provided in step a) is close to that of the metal, which is grown in method steps b) and c) on the substrate. Since the metal applied in method steps b) and c) is preferably copper, it is preferred that the single-crystal substrate provided in step a) is made of a material having an atomic spacing of 0.2 to 0.4 nm. Notably good results are obtained, when the atomic spacing of the single-crystal substrate is 0.24 to 0.33 nm and in particular when the atomic spacing of the single-crystal substrate is 0.25 to 0.30 nm.

Notably suitable materials with the aforementioned atomic spacing are aluminum oxide, diamond and sapphire. Excellent results are e.g. obtained with corundum, diamond (111) and sapphire (0001) or c-plane sapphire, respectively, wherein c-plane sapphire is most preferred. Particularly preferred is c-plane sapphire, because it has a suitable lattice mismatch with copper (111) of 8.6 % leading to an appropriate stress for the peel-off step d). Moreover, c-plane sapphire is an almost perfect insulator, has excellent and manipulable interface properties leading to an easy peel-off of the metal layer in step d), is comparable cheap and can be produced in comparable big dimensions. The substrate may have any geometry and dimensions, such as a cylindrical shape with a diameter of 2.5 to 100 cm, such as about 5 cm, and a thickness of 0.2 to 1 mm, such as about 500 µm.

According to a variant of the aforementioned embodiment of the present invention, a structured substrate may be provided in step a). For example, the structured substrate may be formed by depositing silicon nitride by means of sputtering onto a c-plane sapphire substrate and then patterning the silicon nitride layer as a result of a photoresist layer being applied onto the silicon nitride layer and exposed. Afterwards, the photoresist layer is removed to obtain the patterned substrate.

In principle, the present invention is not particularly limited concerning the nature of the metal applied in method steps b) and c). However, good results are achieved if the metal is selected from one of groups 7 to 12 of the periodic table and preferably from one of groups 8 to 11 of the periodic table. In further development of the present invention, it is suggested that the metal grown in method steps b) and c) onto a surface of the substrate is selected from the group consisting of nickel, cobalt, copper, rhodium, palladium, silver, iridium, platinum, ruthenium, gold and any combinations of two or more of the aforementioned metals. The metal grown in method step b) may be the same or a different one as the metal grown in method step c), wherein it is preferable that the metal grown in method step b) is the same as the metal grown in method step c).

Particular preferably, a layer of a nickel and most preferably of copper is grown in method step b) onto a surface of the substrate.

There is no limitation concerning the manner, by which the metal layer is deposited onto the surface of the substrate in method step b). By way of example, the metal layer may be deposited onto the surface of the substrate in method step b) by means of electron beam evaporation, by means of ion beam sputtering, by means of magnetron sputtering, by means of pulsed laser deposition, by means of atomic layer deposition and/or by means of thermal evaporation.

The thickness of the metal layer produced in method step b) should be large enough that the produced metal layer is strong enough and easy to handle after having been peeled off. Particular good results are obtained, when a metal layer having a thickness of at least 10 nm, preferably of 20 to 100 nm, more preferably of 25 to 75 nm, even more preferably of 30 to 70 nm and most preferably of 40 to 60 nm, such as about 50 nm, is grown on the surface of the substrate. The deposition rate depends on the method used for the epitaxial growth of the metal layer and may be between 0.005 to 0.5 nm/sec, such as between 0.01 to 0.05 nm/sec, for instance about 0.03 nm/sec.

According to a further preferred embodiment of the present invention, the thickness of the metal layer is increased in method step c) to 10 to 50 µm, preferably to 20 to 30 µm and more preferably to 22.5 to 27.5 µm, such as to about 25 µm. Preferably, the metal grown in method step c) is the same as the metal grown in method step b). More preferably, the metal grown in method step c) is nickel and most preferably the metal grown in method step c) is copper.

The present invention is not particularly limited concerning the manner, by which the metal layer is grown in method step c) onto the epitaxially metal layer obtained in method step b). By way of example, the metal layer may be deposited in method step c) onto the surface of the epitaxially metal layer obtained in method step b) by electroplating. However, the present invention is not particularly limited concerning the electroplating conditions. By way of example, the electroplating may be performed at a current density of 1 to 50 mA/cm², preferably at a current density of 5 to 20 mA/cm² and more preferably at a current density of 10 to 20 mA/cm², such as at about 15 mA/cm². While the growth rate is preferably 1 to 50 µm/h, more preferably 5 to 30 µm/h and most preferably 10 to 20 µm/h, such as about 16 µm/h, the electroplating may be performed at a temperature from room temperature to 90 °C and preferably at a temperature of 50 to 70°C, such as at about 60°C.

As an alternative to the aforementioned embodiments, in steps b) an c) semimetal layers, such as silicon layers, or even non-metal layers may be grown. In this case, the graphene film is obtainable with a process comprising the steps of:
a) providing a substrate,
b) epitaxially growing a semimetal layer and/or nonmetal layer on a surface of the substrate,
c) optionally increasing the thickness of the layer obtained in step b) by growing a semimetal and/or nonmetal onto the epitaxially grown layer,
d) peeling off the layer obtained in step b) or optionally in step c) from the substrate and
e) depositing graphene onto at least a part of that surface of the layer obtained in step d), which was in contact with the substrate before the peeling off conducted in step d).

In principle, the layer, preferably metal layer, grown in method step b) and optionally the layers, preferably metal layers, grown in method steps b) and c) may be peeled off from the substrate, preferably the single-crystal substrate, in any suitable manner. For example, the metal layer may be peeled off from the substrate, preferably the single-crystal substrate, by means of a tweezer with a peel off speed between 0.1 and 10 mm/sec, preferably between 0.25 and 2 mm/sec, more preferably between 0.5 and 1.5 mm/sec and most preferably between 0.8 and 1.2 mm/sec, such as about 1 mm/sec. It is a matter of course that the peeling off is effected advantageously by peeling the metal layer from one of its edges to the opposite edge.

Alternatively, the metal layer grown in method step b) and optionally the metal layers grown in method steps b) and c) may be peeled off from the substrate making use of a carrier. In this embodiment, for example, a polymer film may be spin coated onto the metal layer, which is arranged with its side opposite to the surface on the substrate. Afterwards, the substrate is removed from the so obtained composite mechanically, so that a construct comprising the metal layer, e.g. copper layer, and thereon the polymer film is obtained. In principle, the film may be composed of any polymer, which is suitable to be coated as a thin film having a thickness of 0.1 to 100 µm onto a substrate. Good results are in particular achieved, if a film made of polymethyl methacrylate, polycarbonate, polydimethylsiloxane or the like is used. Thereafter, the polymer film may be removed from the construct for example with an organic solvent, such as acetone.

Moreover, it is preferable that peeled off metal layer(s) grown in method step(s) b) and optionally c) has/have a RMS (Root Mean Square) flatness of at most 0.6 nm, more preferably of at most 0.5 nm and even more preferably of at most 0.4 nm.

Even if the present invention is not limited concerning the manner, in which graphene is deposited in the method step e) onto at least a part of the surface of the metal layer, according to a further preferred embodiment of the present invention the graphene is deposited in method step e) by CVD.

The CVD may be performed in any known manner, namely e.g. as microwave plasma CVD, as plasma enhanced CVD (PECVD) or as remote plasma enhanced CVD. Moreover, the CVD may be performed in a cold wall parallel plate system, a hot wall parallel plate system or electron cyclotron resonance. Furthermore, the CVD may be performed as hot filament CVD (HFCVD), metal organic CVD (MOCVD) or atomic layer CVD (ALD).

The CVD may be performed at atmospheric pressure (APCVD), at low pressure (LPCVD) or under vacuum, such as ultra-vacuum (UVCVD). However, it is preferred to perform the CVD at sub-atmospheric conditions, preferably at 1 to 10000 Pa, more preferably at 10 to 1000 Pa and even more preferably at 20 to 500 Pa.

According to another preferred embodiment of the present invention, the pressure during the CVD is between 2 and 500 Pa, more preferably between 10 and 250 Pa, even more preferably between 30 and 120 Pa, particularly preferably between 50 and 100 Pa and most preferably between 50 and 70 Pa, such as for example 61 Pa. If such a pressure is applied during the CVD, sufficiently much initiation sites for graphene crystallization are present so that the graphene growth rate is fast leading within short time to large single-crystalline graphene sections. However, if the pressure during the CVD is lower, the graphene growth rate is significantly lower.

Moreover, it is preferred that the CVD is performed in an atmosphere comprising a mixture of a hydrocarbon gas and hydrogen and preferably in an atmosphere comprising a mixture of methane and hydrogen. It is also preferred that the mixture comprises more hydrogen than hydrocarbon gas or methane, respectively. Preferably, the flow ratio of methane to hydrogen during the CVD is from 1:1 to 1:10, more preferably from 1:2 to 1:5 and most preferably from 1:3 to 1:4, such as for instance about 1:3.3. Furthermore, it is preferred that the atmosphere consists of the aforementioned compounds, i.e. dos not include further compounds in addition to the hydrocarbon gas and hydrogen. If further compounds are present, the further compounds are preferably inert gases, such as nitrogen, argon, helium or the like.

The CVD may be conducted at a temperature between 900 and 1100 °C for 1 to 40 min, such as at a temperature between 950 and 1000 °C for 5 to 20 min, for example at a temperature of about 1000 for about 10 min.

According to a further preferred embodiment of the present invention, the graphene film may be a doped graphene film, preferably a graphene film doped with any element selected from the group consisting of nitrogen, boron, sulfur, phosphor, silicon and any combination thereof, and preferably a graphene film doped with nitrogen and/or boron. In order to obtain such a graphene film doped for example with nitrogen, preferably in step e) nitrogen doped graphene is deposited by chemical vapour deposition, wherein the chemical vapour deposition is more preferably performed in an atmosphere comprising a nitrogen containing substance, such as ammonia, an amine, like methylamine and/or ethylamine, or a triazine, such as 1,3,5-triazine. The nitrogen content in the graphene may be for instance up to 2 % by mole. More specifically, a graphene film doped with nitrogen may be obtained by depositing in step e) nitrogen doped graphene by chemical vapour deposition, which is performed in an atmosphere comprising 1,3,5-triazine and optionally hydrogen at a temperature of 500 to 1000 °C for 1 to 60 min at a total pressure of at most 1 kPa. Preferably, the pressure during the CVD is between 2 and 500 Pa, more preferably between 10 and 250 Pa, even more preferably between 30 and 120 Pa, particularly preferably between 50 and 100 Pa and most preferably between 50 and 70 Pa, such as for example 61 Pa. More specifically, the n-doped graphene may be prepared as follows: The surface of the metal layer obtained in step d), which was in contact with the substrate before the peeling off conducted in step d), is firstly subjected to a mixture of hydrogen and argon at a total pressure of for example 65 kPa at a temperature of 1000 °C for 30 min. After that annealing step, the sample is cooled down to 500 °C and evacuated, before the sample is subjected to 1,3,5-triazine at 500 °C for 20 min. Then, the supply of the 1,3,5-triazine is stopped and the sample is heated to a temperature between 700 and 900°C in an atmosphere consisting of a mixture of hydrogen and argon at a total pressure of for example 0.65 kPa for 10 min. In order to obtain such a graphene film doped for example with boron, preferably in step e) boron doped graphene is deposited by chemical vapour deposition, wherein the chemical vapour deposition is more preferably performed in an atmosphere comprising a boron containing substance, such as borane or boron trichloride.

As a result of the above described methods, a composite is obtained, in which the graphene film is arranged on the surface of a metal layer, such as in particular a copper film. If the graphene film is to be transferred to another substrate, this may be accomplished by spin coating a polymer film, such as a film of polymethyl methacrylate, after the method step e) onto the free side of the desired graphene film which is present on that side of the copper film, which before the peel off step was in direct contact with the c-plane sapphire substrate, and thereafter by plasma etching the so obtained composite in order to remove the graphene layer opposite to the side protected by the polymethyl methacrylate film, before the remaining structure is etched in a copper etchant, such as in an ammonium persulfate solution, in order to remove the metal layer. Afterwards, the composite consisting of the graphene film and the polymethyl methacrylate film is transferred onto a target substrate and then the polymethyl methacrylate is removed with an organic solvent, such as acetone. Instead of a film of polymethyl methacrylate a film made of any other polymer being suitable to be coated as a thin film having a thickness of 0.1 to 100 µm may be used, such as a film of polycarbonate, polydimethylsiloxane or the like. Moreover, instead of an ammonium persulfate ((NH₄)₂S₂O₈) solution, any other copper etchant may be used, such as iron nitrate ((Fe(NO₃)₂), iron chloride (FeCl₃) or the like.

As mentioned above, the graphene according to the present invention has an extraordinarily high charge carrier mobility, comprises very large graphene domains, has an excellent lattice quality and has an excellent optical transparency.

According to a preferred embodiment of the present invention, the graphene according to the present invention has a charge carrier mobility of more than 11000 cm²/V·sec, when measured via the field effect characteristics of graphene on a SiO₂ substrate. According to the present invention the charge carrier mobility measured via the field effect characteristics of graphene on a SiO₂ substrate is calculated by measuring the field-effect characteristics of graphene devices in liquid. Graphene sheets are transferred onto chips with pre-patterned electrodes called source (S) and drain (D) on SiO₂/Si. The chip along with the electrodes and the graphene sheet is brought in contact with a droplet of water containing 10 mM KCl. Subsequently, an Ag/AgCl reference electrode is immersed into the droplet. This electrode acts as the gate. The resistance of the graphene sheet across the S - D electrodes (typical electrode spacing: 4 µm) is measured as a function of the voltage applied to the gate electrode. In this configuration, the electrical double layer at the graphene/liquid interface serves as the gate capacitor. In order to arrive at the charge carrier mobility, a procedure similar to that outlined by T. Fang et al. in Appl. Phys. Lett. 2007, vol. 91, 092109 is used. A modified Drude model is used, whereby the resistance of the graphene sheet is given by ρ(E_{F}) = 1/[eµ{n(E_{F})+p(E_{F})}], where µ is constant mobility and e is the electronic charge. The n and p are the charge carrier concentrations (for electrons and holes respectively) given by Eqn. (3) and (2) by T. Fang et al. in the paper Appl. Phys. Lett. 2007, vol. 91, 092109. The E_{F} is the Fermi level, which can be set using the gate voltage V_{G}. For the modeling strategy, the Fermi level could be defined as E_{F} = αeV_{G}, where α is the gate coupling efficiency, which indirectly incorporates the gate capacitance. The measured data could be fit to this model to obtain best-fit parameters α and µ. In addition to these parameters, the Dirac point and an empirical contact resistance could be used to obtain an optimal fit.

Preferably, the graphene film according to the present invention has a mobility, when measured via the field effect characteristics of graphene on a SiO₂ substrate, of at least 15000 cm²/V·sec, more preferably of at least 20000 cm²/V·sec, even more preferably of at least 22500 cm²/V·sec, still more preferably of at least 25000 cm²/V·sec, still more preferably of at least 27500 cm²/V·sec and most preferably of at least 30000 cm²/V·sec.

According to a further preferred embodiment, the graphene film according to the present invention has a charge carrier mobility of at least 50000 cm²/V·sec, when measured via the Hall effect.
- Fig. 1: is a schematic view of a device for measuring the charge carrier mobility of a graphene film via the Hall effect.
- Fig. 2a: is a schematic view of the Hall mobility measurement device with nominal channel widths of 1 µm and lengths of 1.5 µm using electron beam lithography and oxygen plasma etching.
- Fig. 2b: is an optical microscope image of the fabricated Hall device.

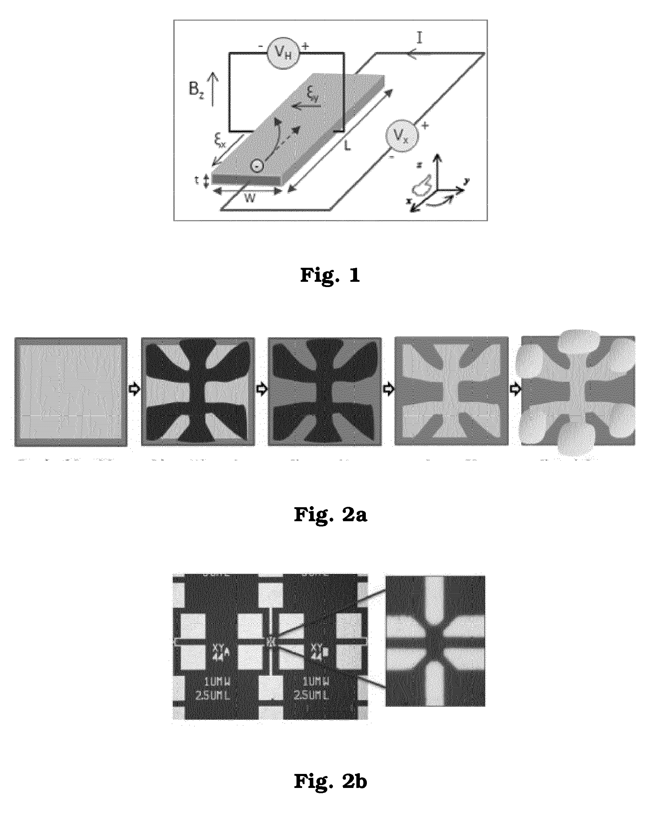

In this method initially the electrons follow the curved arrow in Fig. 1 due to the magnetic force. At some distance from the current-introducing contacts, electrons pile up on the left side and deplete from the right side, which creates an electric field ξy. In steady-state, ξy will be strong enough to exactly cancel out the magnetic force, so that the electrons follow the straight arrow (dashed arrow in Fig. 1). By measuring this electric field, the Hall voltage; V_{H} = ξ_{y}·W can be measured. This Hall voltage makes the force balance; q·ξ_{y} = q·vₓ·B_{z}, where vₓ is charge velocity in x direction, B_{z} is magnetic field in z direction. Then, the electron concentration n = _{Ix·}B_{z} / e·t·V_{H} is calculated, wherein e is the Coulomb constant and t is thickness of material because: vₓ = Iₓ/e·n·W·t. Finally, the mobility is obtained based on the current density equation: Iₓ /Wt = e·n·µ·ξx, wherein µ = Iₓ·L/e·n·Vₓ·W·t, because = V_{x/}L. More specifically, the charge carrier mobility of the graphene film by the Hall effect is measured with a device as shown in Fig. 2a and 2b. The graphene samples are patterned into Hall bars with nominal channel widths of 1 µm and lengths of 1.5 µm using electron beam lithography and oxygen plasma etching. Then, a lithography step is used to pattern electrodes (Cr/Pd/Au) onto the device. After the device processing, the samples are annealed in a tube furnace under a forming gas background for 4.5 hours at 345 °C to have a clean surface. Then the Hall mobility measurement is conducted at a low temperature of 1.6 K.

Preferably, the graphene film according to the present invention has a mobility, when measured via the Hall effect, of at least 60000 cm²/V·sec, more preferably of at least 70000 cm²/V·sec, even more preferably of at least 80000 cm²/V·sec, yet more preferably of at least 90000 cm²/V·sec and most preferably of at least 100000 cm²/V·sec.

Alternatively to the above mentioned embodiments or, preferably, in addition to the charge carrier mobilities of the aforementioned embodiments, the graphene film in accordance with the present invention comprises one or more single-crystalline sections, wherein the average diameter d₅₀ of all single-crystalline sections is more than 2 µm, preferably at least 10 µm, more preferably at least 25 µm, even more preferably at least 50 µm, further preferably at least 75 µm and most preferably at least 100 µm. In accordance with the usual definition of this parameter, the average diameter d₅₀ of the single-crystalline sections denotes the value of the diameter of the single-crystalline sections, below which 50% of all single-crystalline sections lie, i.e. 50% of all single-crystalline sections of the graphene have a smaller diameter than the d₅₀ value. According to the present invention the average diameter is measured with liquid crystal optical polarization, such as described in Nature Nanotech. 2012, vol. 7, pages 29 to 34 and by Kin et al.

Alternatively to the above mentioned embodiment or, preferably, in addition to the aforementioned d₅₀-diameter of the aforementioned embodiment, it is preferred that the graphene film comprises one or more single-crystalline sections, wherein the average diameter d₉₀ of the single-crystalline sections is more than 10 µm, preferably at least 50 µm, more preferably at least 100 µm, even more preferably at least 200 µm, further preferably at least 250 µm and most preferably at least 300 µm. In the same way as the definition of the average d₅₀-diameter, the average diameter d₉₀ of the single-crystalline sections denotes the value of the diameter of the single-crystalline sections, below which 90% of all single-crystalline sections lie, i.e. 90% of all single-crystalline sections of the graphene have a smaller diameter than the d₉₀ value.

Alternatively or, preferably, in addition to the aforementioned d₅₀-diameter and/or d₉₀-diameter of the aforementioned embodiments, the graphene film preferably comprises one or more single-crystalline sections, wherein the average diameter d₁₀ of the single-crystalline sections is more than 0.2 µm, preferably at least 1 µm, more preferably at least 2.5 µm, even more preferably at least 5.0 µm, further preferably at least 7.5 µm and most preferably at least 10 µm. In the same way as the definition of the average d₅₀- and d₉₀-diameter, the average diameter d₁₀ of the single-crystalline sections denotes the value of the diameter of the single-crystalline sections, below which 10% of all single-crystalline sections lie, i.e. 10% of all single-crystalline sections of the graphene have a smaller diameter than the d₁₀ value.

As set out above, the graphene film according to the present invention has a high lattice-quality, which may be characterized by its Raman spectrum. According to a particular preferred embodiment of the present invention, the graphene film is characterized by a Raman spectrum, in which the ratio I(2D)/I(G*) is at least 5:1, preferably at least 10:1 1 and more preferably at least 40:1, wherein I(2D) is the intensity of the 2D-band and I(G*) is the intensity of the G*-band in the Raman spectrum. This ratio is a measure for the number of graphene layers and the higher this ratio, the lower the number of graphene layers. Preferably, the Raman spectrum is obtained with a Raman spectrometer LabRAM HR 800 from the company HORIBA Yvon GmbH at the following conditions: excitation wavelength of the laser: He-Ne 633 nm, spot size of the laser beam: 5 µm in diameter, measurement time: 20 sec. The Raman spectrum is measured at five different, arbitrarily selected regions on the graphene film, wherein at each location the measurement is performed twice. All measurement values are accumulated and, for the determination of the peak intensity, the respective background is subtracted. Preferably, the determination of the peak intensities is conducted with the software LabSpec Vers. 5 from the company HORIBA Yvon GmbH.

In a further variant of the present invention, the graphene film is characterized by a Raman spectrum, in which the ratio of I(2D)/I(G) is at least 1:1, preferably at least 2:1 and more preferably at least 4:1, wherein I(2D) is the intensity of the 2D-band and I(G) is the intensity of the G-band in the Raman spectrum. Also this ratio is a measure for the number of graphene layers and the higher this ratio, the lower the number of graphene layers.

As set out above, the graphene according to the present invention has a very high optical transparency. Preferably, the graphene film has an optical transparency of at least 95%, preferably of at least 97.5% and more preferably of at least 99%, wherein the optical transparency is measured on transparent quartz substrate. The optical transparency spectrum is obtained with an optical measurement system composed of a tungstenhalogen lamp and a monochromator as a light source and a photomultiplier tubes as a detector (SpectraPro-300i monochromator from Acton research corporation) at the following conditions: wavelength range: 380 to about 1200 nm, spot size of light source: 4 mm² square, measurement speed 1 sec/1 nm. The optical transparency spectrum is measured at five different, arbitrarily selected regions on the graphene film, wherein at each location the measurement was performed twice. The respective background (bare quartz substrate) is also measured for the subtractions.

Furthermore, the present invention relates to a graphene film having a charge carrier mobility of more than 11000 cm²/V·sec, when calculated by measuring the field-effect characteristics of graphene devices in liquid.

A further subject matter of the present invention is a graphene film, which comprises one or more single-crystalline sections, wherein the average diameter d₅₀ of the single-crystalline sections is more than 2 µm, preferably at least 10 µm, more preferably at least 25 µm, even more preferably at least 50 µm, further preferably at least 75 µm and most preferably at least 100 µm.

In addition, the present invention relates to a composite comprising a substrate and a graphene film in accordance with one of the preceding claims bonded to at least a part of at least one surface of the substrate. Preferably, the substrate is a copper sheet, a SiO₂-wafer, a Si-film or the like.

In an alternative embodiment of the present invention, the graphene film is not bonded to any substrate, but is dispersed in a solvent, such as in water or in an organic solvent, such as in ethanol or the like. In a further alternative embodiment, the graphene film is just arranged on a substrate, but not bonded thereto.

A further subject matter of the present invention is graphene oxide, which is obtainable by oxidation of the graphene according to the present invention described above, e.g. by performing an ultraviolet-ozone (UVO) treatment. The UVO treatment may be performed for example by making use of an ozone generating UV lamp (e.g. from UV-Consulting Peschul, Product No. 85026, wavelength: 254 nm and partially 185 nm) with an UV power of e.g. 6.2 Watt at 254 nm and at a distance from the UV lamp to graphene surface of about 1 mm. After UVO treatment, the contact angle of surface can be checked, in order to simply assess whether and to what degree the graphene surface has changed to graphene oxide. For instance, the contact angle for surface energy (dispersion + polar) may be calculated using the geometric mean equation (1+*cos*θ)γ*ₚₗ* = 2(γ*ₛ^{d}*γ*ₚₗ^{d}*)^{1/2} + 2(γ*ₛ^{p}*γ*ₚₗ^{p}*)^{1/2}, where γ*ₛ* and γ*ₚₗ* are the surface energies of the sample and the probe liquid, respectively, and the superscripts *d* and *p* refer to the dispersion and polar (non-dispersion) components of the surface energy, respectively. For example, two kinds of probe liquid may be used, such as deionized water (γ*ₚₗ^{d}* is 72.8 mJ/m², γ*ₚₗ^{p}* is 21.8 mJ/m²) and diiodomethane (γ*ₚₗ^{d}* is 50.8 mJ/m², γ*ₚₗ^{p}* is 48.5 mJ/m²). Based on this measurement the surface energy of graphene sheet can be calculated and modulated. As described in the document Langmuir 2009, 25 (18), pages 11078 to 11081, it can be determined, whether and, if applicable, to which extent the graphene sheet has changed by the UVO treatment to graphene oxide.

Moreover, the present invention relates to a method for producing a graphene film in accordance with one of the preceding claims, which comprises the following steps:
a) providing a substrate and preferably a single-crystal substrate,
b) epitaxially growing a metal layer on a surface of the substrate,
c) optionally increasing the thickness of the metal layer obtained in step b) by for example electroplating a metal and preferably the same metal as in step b) onto the epitaxially grown metal layer,
d) peeling off the metal layer obtained in step b) and optionally in step c) from the substrate and
e) depositing graphene onto at least a part of that surface of the metal layer obtained in step d), which was in contact with the substrate before the peeling off conducted in step d).

Finally, the present invention relates to the use of the above described graphene film or of the above described composite i) in an electrode, preferably in a capacitor, lithium battery, fuel cell, hydrogen gas storage, solar cell, heat controlling assembly or energy storage system, ii) in an electronic device, preferably as a transparent electrode, in a touch screen display, in thermal management, in a gas sensor, in a transistor or in a memory device, or in a laser, such as tunable fiber mode-locked laser, solid-state mode-locked laser or passively mode-locked semiconductor laser, or in a photodetector, polarization controller or optical modulator, iii) in a coating, preferably in an anti-icing coating, in a wear-resistant coating, in a selfcleaning coating or in an antimicrobial coating, iv) in a building construction, preferably in a structural reinforcement for automotives an constructions, v) as catalyst, vi) as an anti-microbial packaging, vii) as a graphene rubber, viii) as a sporting good, ix) as an isolator, x) as a sensor, preferably a biosensor, such as for measuring a magnetic field, for DNA sequencing, for monitoring the velocity of surrounding liquid or for a strain gauge, or xi) anything else where the properties of the here disclosed invention are suitable.

Subsequently, the present invention will be described in more detail by way of a non-limiting example and a comparative example.

### Example 1

A graphene film was prepared by a process comprising the following steps:
a) providing a single-crystal substrate,
b) epitaxially growing a metal layer on a surface of the single-crystal substrate,
c) increasing the thickness of the metal layer obtained in step b) by electroplating the same metal onto the epitaxially grown metal layer,
d) peeling off the metal layer from the single-crystal substrate and
e) depositing graphene onto at least a part of that surface of the metal layer obtained in step d), which was in contact with the single-crystal substrate before the peeling off conducted in step d).

The aforementioned steps were performed as described below.

### Growth of epitaxial Copper Film on Sapphire

A c-plane sapphire substrate (Crystalbank in the Pusan National University, South Korea, 99.998%, C-plane, 5,1 cm diameter, 500 µm thick) was used as a starting substrate. This substrate was cleaned sequentially with acetone, isopropyl alcohol and de-ionized water.

Then a copper film was deposited onto the surface of the single-crystal substrate by electron beam deposition making use of a high purity copper source from Sigma-Aldrich (item number: 254177, copper beads having a particle size of 2 to 8 mm, 99.9995 % trace metals basis) making use of a Multi-Pocket electron beam source from TELEMARK performed with 6.5 kV and 120 mA beam current. The chamber pressure was maintained during deposition at 10⁻⁶ Torr and the substrate temperature was room temperature. With this, a copper film was grown on the substrate at a rate of 0.03 nm/sec to a final thickness of 50 nm.

### Copper Plating on epitaxial Copper Film

A cathode (namely the 50 nm copper film on c-plane sapphire obtained in the aforementioned method step) and an anode (bulk copper stick) were electrically connected with a Keithley 2400 digital sourcemeter and then the electroplating was performed at a temperature of 60°C at a constant current density of 15 mA/cm² and at a voltage between the electrodes between 0.2 and 0.3 V. The growth rate of the copper film was about 16 µm/h and the electroplating was stopped, when the copper film reached a final thickness of 25 µm.

### Peel off of the Copper Film (epitaxial Copper film + Copper plating)

Subsequently, the copper film was peeled off from the single-crystal substrate with a tweezers having a flat point (width: 1.50 mm; thickness: 0.20mm), wherein due to the strong compressive stress of the comparatively thick copper film on the c-plane sapphire substrate an edge of the copper film was initially slightly peeled, whereafter the copper film was peeled off from the substrate with a rate of 1 mm/sec.

### Synthesis of Graphene on peeled off Copper Film

The peeled off copper film was put into a quartz tube reaction chamber with 25.4 mm diameter and 1200 mm length. One side was connected to a gas inlet and the other side was connected to a mechanical pump. The complete quartz tube was covered by a box furnace for the uniform heating. Graphene was deposited onto the copper film by CVD as follows:
(1) The pressure in the growth chamber was reduced to 2.3 mTorr using a mechanical pump.
(2) Hydrogen gas was fed into the chamber at 950 mTorr and at a flow rate of 40 sccm.
(3) Then, the copper film was heated to 1000°C for 60 min.
(4) Thereafter, a mixture of methane gas with a flow rate of 6 sccm and hydrogen with a flow rate of 20 sccm was introduced into the chamber for 10 min with a total pressure of 420 mTorr for graphene synthesis.
(5) After the completion of the growth, the furnace was rapidly cooled down to room temperature under a 20 sccm flow of hydrogen.

### Transfer of Graphene to the Target Substrate (SiO₂/Si(100))

Firstly, one side of the composite - namely the free side of the desired graphene film which is present on that side of the copper film, which before the peel off step was in direct contact with the c-plane sapphire substrate - was spin coated with polymethyl methacrylate (PMMA) at 2000 rpm for 60 sec and then dried for 1 h at ambient. Then the composite was etched with an oxygen plasma for 30 sec at 100 W in order to remove the graphene on the side of the composite, which is opposite to the PMMA layer. Afterwards, the composite was etched in a (NH₄)₂S₂O₈ solution (0.3 M) for 12 hours in order to remove the copper layer, before the graphene/PMMA film was washed in de-ionized water for several times. The so obtained graphene/PMMA-film was transferred onto a target substrate, namely thermal SiO₂ covered Si wafer, and dried at ambient for 24 hours and heat treated at 180°C for 30 min to increase the adhesion between the graphene and the target substrate. Finally, the PMMA layer was removed sequentially with acetone, isopropyl alcohol and de-ionized water.

Afterwards, the graphene was evaluated on the target substrate with respect to its charge carrier mobility, the average diameter of the single-crystalline sections thereof, its Raman spectrum and its optical transparency as follows.

### Charge Carrier Mobility Measurement

The charge carrier mobility was calculated by measuring the field-effect characteristics of graphene devices in liquid. Graphene sheets were transferred onto chips with pre-patterned electrodes called source (S) and drain (D) on SiO₂/Si. The chip along with the electrodes and the graphene sheet was brought in contact with a droplet of water containing 10 mM KCl. Subsequently an Ag/AgCl reference electrode was immersed into the droplet. This electrode acted as the gate. The resistance of the graphene sheet across the S - D electrodes (typical electrode spacing: 4 microns) was measured as a function of the voltage applied to the gate electrode. In this configuration, the electrical double layer at the graphene / liquid interface served as the gate capacitor. In order to arrive at the charge carrier mobility, a procedure similar to that outlined by T. Fang et al. in Appl. Phys. Lett. 2007, vol. 91, 092109 was used. A modified Drude model was used, whereby the resistance of the graphene sheet was given by ρ(E_{F}) = 1/[eµ{n(E_{F})+p(E_{F})}], where µ is constant mobility and e is the electronic charge. The n and p are the charge carrier concentrations (for electrons and holes respectively) given by Eqn. (3) and (2) by T. Fang et al. in Appl. Phys. Lett. 2007, vol. 91, 092109. The E_{F} is the Fermi level, which can be set using the gate voltage V_{G}. For the modeling strategy, the Fermi level could be defined as E_{F} = αeV_{G}, where α is the gate coupling efficiency, which indirectly incorporates the gate capacitance. The measured data could be fit to this model to obtain best-fit parameters α and µ. In addition to these parameters, the Dirac point and an empirical contact resistance could be used to obtain an optimal fit.

### Average diameter of the single-crystalline graphene sections

Liquid crystals from Sigma-Aldrich (item number: 328510, 4'-Pentyl-4-biphenylcarbonitrile liquid crystal (nematic), 98%) were directly spincoated onto the graphene surface at 2000 r.p.m. Below the isotropic transition temperature of the liquid crystals (40°C), the grain distribution of graphene using polarized light in conventional optical microscope is seen by checking the distribution of the liquid crystal on graphene. From this, the average diameter d₅₀ of the single-crystalline graphene sections was determined as described in Nature Nanotech. 2012, vol. 7, pages 29 to 34 and by Kin et al.

### Measurement of the Raman Spectrum

For the Raman spectrum, the graphene on the SiO₂/Si substrate was used. The Raman spectrum was obtained with a Raman spectrometer LabRAM HR 800 from the company HORIBA Jobin Yvon GmbH at the following conditions: excitation wavelength of the laser: He-Ne 633 nm, spot size of the laser beam: X 5 µm in diameter, measurement time: 20 sec. The Raman spectrum was measured at five different, arbitrarily selected regions on the graphene film, wherein at each location the measurement was performed twice. All measurement values were accumulated and, for the determination of the peak intensity, the respective background (Si02/Si) was subtracted. Preferably, the determination of the peak intensities was conducted with the software LabSpec Version 5 from the company HORIBA Jobin Yvon GmbH.

### Measurement of the optical Transparency

For the optical transparency spectrum, graphene transferred on transparent quartz substrate was used. The optical transparency spectrum was obtained with an optical measurement system composed of a tungstenhalogen lamp and a monochromator as a light source and a photomultiplier tubes as a detector (SpectraPro-300i monochromator from Acton research corporation) at the following conditions: wavelength range: 380 to about 1200 nm, spot size of light source: 4 mm² square, measurement speed 1 sec/1 nm. The optical transparency spectrum was measured at five different, arbitrarily selected regions on the graphene film, wherein at each location the measurement was performed twice. The respective background (bare quartz substrate) was also measured for the subtractions.

The results are summarized in the below table.

| | Graphene of Example |
|---|---|
| Mobility (cm²/V·sec) | 29000 |
| Diameter d₅₀ of the Graphene Single-Crystalline Sections (µm) | 75 to 100 |
| Ratio I(2D)/I(G*) in Raman Spectrum | 20 to 25 |
| Ratio I(2D)/I(G) in Raman Spectrum | 3 to 3.5 |
| Optical Transparency (%) | 93 to 98 |

### Comparative Example 1

A copper foil having a purity of 99.8 %, which is commercially available under the trade name Alfa Aesar, item number 13382, was provided and etched by dipping it into an ammonium persulfate ((NH₄)₂S₂O₈) solution. Afterwards, a graphene film was deposited by CVD onto the surface of this copper foil as described above for example 1 except that a reductive preannealing step in hydrogen at 1000 °C has been performed for 30 min.

After the CVD, the obtained graphene film was transferred to a SiO₂/Si (100) target substrate and then analyzed as described above for example 1.

Accordingly, the domain size or average diameter d₅₀ of the single-crystalline graphene sections of the graphene film of comparative example 1, respectively, was about 1 µm, which is about two magnitudes of order lower than that of the graphene sections of the graphene film of example 1.

Moreover, the graphene film obtained with comparative example 1 shows in the Raman spectrum a weak D-band, whereas the graphene film obtained with example 1 has no detectable D-band.

In addition, the graphene film obtained with comparative example 1 has a charge carrier mobility of about 5000 cm²/V·sec, which is significantly less than 29000 cm²/V·sec as measured for the graphene film obtained with example 1.

### Example 2

A graphene film produced in example 1 was converted into graphene oxide by performing an ultraviolet-ozone (UVO) treatment. The UVO treatment was performed making use of an ozone generating UV lamp (from UV-Consulting Peschul, Product No. 85026, wavelength: 254 nm and partially 185 nm) with an UV power of 6.2 Watt at 254 nm and at a distance from the UV lamp to graphene surface of about 1 mm for 8 minutes.

After the UVO treatment, the contact angle of surface was checked, in order to assess whether the graphene surface has changed to graphene oxide. More specifically, the contact angle for surface energy (dispersion + polar) was calculated using the geometric mean equation (1+cosθ)γ*ₚₗ* = 2(γ*ₛ^{d}*γ*ₚₗ^{d}*)^{1/2} + 2(γ*ₛ^{p}*γ*ₚₗ^{p}*)^{1/2}, where γ*ₛ* and γ*ₚₗ* are the surface energies of the sample and the probe liquid, respectively, and the superscripts *d* and *p* refer to the dispersion and polar (non-dispersion) components of the surface energy, respectively. Two kinds of probe liquid were used, namely deionized water (γ*ₚₗ^{d}* is 72.8 mJ/m², γ*ₚₗ^{p}* is 21.8 mJ/m²) and diiodomethane (γ*ₚₗ^{d}* is 50.8 mJ/m², γ*ₚₗ^{p}* is 48.5 mJ/m²).

Based on this measurement the surface energy of graphene sheet was calculated and modulated. Based on the description in the document Langmuir 2009, 25 (18), pages 11078 to 11081, it was determined that the graphene film (surface energy of 46.7 mJ/m²) changed by the UVO treatment to graphene oxide (surface energy of 62.1 mJ/m²).

## Claims

1. A graphene film, which is obtainable with a process comprising the steps of:
a) providing a substrate,
b) epitaxially growing a metal layer on a surface of the substrate,
c) optionally increasing the thickness of the metal layer obtained in step b) by growing a metal onto the epitaxially grown metal layer,
d) peeling off the metal layer obtained in step b) or optionally in step c) from the substrate and
e) depositing graphene onto at least a part of that surface of the metal layer obtained in step d), which was in contact with the substrate before the peeling off conducted in step d).

2. The graphene film in accordance with claim 1, wherein the substrate provided in step a) is a single-crystal substrate and/or wherein the substrate is made of aluminum oxide, diamond or sapphire and preferably of corundum, diamond (111) or sapphire (0001).

3. The graphene film in accordance with claim 1 or 2, wherein in step b) a layer of a nickel and preferably of copper is grown on a surface of the substrate and/or in step c) a layer of nickel and preferably of copper is grown onto the epitaxially grown metal layer obtained in step b).

4. The graphene film in accordance with one of the preceding claims, wherein in step d) the metal layer is peeled off from the substrate by means of a tweezer with a peel off speed between 0.1 and 10 mm/sec, preferably between 0.25 and 2 mm/sec, more preferably between 0.5 and 1.5 mm/sec and most preferably between 0.8 and 1.2 mm/sec.

5. The graphene film in accordance with one of the preceding claims, wherein in step e) the graphene is deposited by chemical vapour deposition, wherein the chemical vapour deposition is preferably performed in an atmosphere comprising methane and hydrogen at a temperature of 900 to 1100 °C for 5 to 20 min.

6. The graphene film in accordance with one of the preceding claims, wherein in step e) nitrogen and/or boron doped graphene is deposited by chemical vapour deposition, wherein the chemical vapour deposition is preferably performed in an atmosphere comprising a substance selected from the group consisting of borane, boron trichloride, ammonia, amines, triazines and combinations thereof at a temperature of 500 to 1000 °C for 1 to 60 min at a total pressure of at most 1 kPa.

7. The graphene film in accordance with one of the preceding claims, which has a charge carrier mobility of more than 11000 cm²/V·sec, when measured via the field effect characteristics of graphene on a SiO₂ substrate.

8. The graphene film in accordance with claim 7, which has a mobility of at least 15000 cm²/V·sec, preferably of at least 20000 cm²/V·sec, more preferably of at least 22500 cm²/V·sec, even more preferably of at least 25000 cm²/V·sec, yet more preferably of at least 27500 cm²/V·sec and most preferably of at least 30000 cm²/V·sec, when measured via the field effect characteristics of graphene on a SiO₂ substrate.

9. The graphene film in accordance with one of the preceding claims, which has a mobility of at least 50000 cm²/V·sec, preferably of at least 60000 cm²/V·sec, more preferably of at least 70000 cm²/V·sec, even more preferably of at least 80000 cm²/V·sec, yet more preferably of at least 90000 cm²/V·sec and most preferably of at least 100000 cm²/V·sec, when measured via the Hall effect.

10. The graphene film in accordance with one of the preceding claims, which comprises one or more single-crystalline sections, wherein the average diameter d₅₀ of the single-crystalline sections is more than 2 µm, preferably at least 10 µm, more preferably at least 25 µm, even more preferably at least 50 µm, further preferably at least 75 µm and most preferably at least 100 µm.

11. The graphene film in accordance with one of the preceding claims **characterized by** a Raman spectrum, in which the ratio I(2D)/I(G*) is at least 5:1, preferably at least 10:1 1 and more preferably at least 40:1, wherein I(2D) is the intensity of the 2D-band and I(G*) is the intensity of the G*-band in the Raman spectrum.

12. A graphene film having a charge carrier mobility of more than 11000 cm²/V·sec, when measured via the field effect characteristics of graphene on a SiO₂ substrate.

13. A graphene film, which comprises one or more single-crystalline sections (domains), wherein the average diameter d₅₀ of the single-crystalline sections is more than 2 µm, preferably at least 10 µm, more preferably at least 25 µm, even more preferably at least 50 µm, further preferably at least 75 µm and most preferably at least 100 µm.

14. A method for producing a graphene film in accordance with one of the preceding claims, which comprises the following steps:
a) providing a substrate and preferably a single-crystal substrate,
b) epitaxially growing a metal layer on a surface of the substrate,
c) optionally increasing the thickness of the metal layer obtained in step b) by for example electroplating a metal onto the epitaxially grown metal layer, wherein the metal is preferably the same as that applied in step b),
d) peeling off the metal layer obtained in step b) and optionally in step c) from the substrate and
e) depositing graphene onto at least a part of that surface of the metal layer obtained in step d), which was in contact with the substrate before the peeling off conducted in step d).

15. Use of a graphene film in accordance with one of claims 1 to 13 in an electrode, preferably in a capacitor, lithium battery, fuel cell, hydrogen gas storage, solar cell, heat controlling assembly or energy storage system, in an electronic device, preferably as a transparent electrode, in a touch screen display, in thermal management, in a gas sensor, in a transistor or in a memory device, or in a laser, such as tunable fiber mode-locked laser, solid-state mode-locked laser or passively mode-locked semiconductor laser, or in a photodetector, polarization controller or optical modulator, in a coating, preferably in an anti-icing coating, in a wear-resistant coating, in a selfcleaning coating or in an antimicrobial coating, in a building construction, preferably in a structural reinforcement for automotives an constructions, as catalyst, as an anti-microbial packaging, as a graphene rubber, as a sporting good, as an isolator, or as a sensor, preferably a biosensor, such as for measuring a magnetic field, for DNA sequencing, for monitoring the velocity of surrounding liquid or for a strain gauge.
